# EUROPEAN PATENT APPLICATION

(11) **EP 0 806 794 A2**
(43) Date of publication of application: **12.11.1997**
(21) Application number: 97106982.8
(22) Date of filing: 28.04.1997
(51) Int. Cl.: H01L 21/265, H01L 29/08

(54) **Method of forming shallow doped regions in a semiconductor substrate, using preamorphization and ion implantation**

(30) Priority: 29.04.1996 US 16397
(71) Applicant: TEXAS INSTRUMENTS INCORPORATED, Dallas Texas 75265 (US)
(72) Inventor: Sultan, Akif, Austin, Texas (US); List, Richard Scott, Dallas, Texas (US); McNeil, Vincent Maurice, Dallas, Texas (US)
(74) Representative: Schwepfinger, Karl-Heinz, Dipl.-Ing.

(57) **Abstract**

A method for tailoring the dopant profile of a doped region. A sub-amorphization implant of a non-electrically active material such as silicon or germanium is performed before a dopant implant. The energy of the amorphization implant is optimized to achieve the desired dopant profile. A lower energy, for example, produces a gradual junction, whereas, a higher energy can be used to produce a shallower junction region. In one application of the invention, a drain extension region of a MOSFET is formed using a sub-amorphization implant of silicon or germanium prior to a implant of boron. The energy of the sub-amorphization implant is chosen so that the projected range of the sub-amorphization implant is greater than three times the as-implanted junction depth of the boron implant in amorphous silicon. This places the interstitials away from the junction region to reduce TED.

## Description

### FIELD OF THE INVENTION

This invention generally relates to semiconductor processing and more specifically to shallow junction diffused regions.

### BACKGROUND OF THE INVENTION

The evolution of integrated circuits has involved scaling down the device geometries. As the channel length of the metal oxide semiconductor field effect transistor (MOSFET) is scaled, it has become necessary to reduce the source/drain (S/D) junction depths (in the drain extension regions near the channel) to prevent short channel effects. However, the formation of shallow p+/n S/D junctions using boron (B⁺) implants is facing severe physical limitations.

Conventionally, to reduce the junction depth the implant energy is reduced, which reduces the projected range (Rₚ) of the dopants. For low energy B+ implants (less than 10 keV) it is not possible to reduce the junction depth significantly by reducing the energy of the implant. The channeling tail during the B+ implant and transient enhanced diffusion (TED) during the subsequent anneal step results in junction depths that are much deeper than expected. TED results from the boron dopant combining with interstitials in the silicon. The boron-interstitial combination diffuses much faster during the anneal than the boron alone causing deeper junction depths. Moreover, implants below 5 keV are not very practical using today's equipment due to low beam currents.

Alternatively, boron-fluoride (BF₂) implants may be used to obtain shallow p+/n junctions. The effective B⁺ implant energy is reduced by a factor of 11/49 using a BF₂ implant. However the BF₂ implants are also characterized by a channeling tail during implant and TED during anneal, although the problem is not as severe as for B⁺ implants. Use of BF₂ also introduces fluorine which may lead to additional complications. Fluorine enhances boron penetration though the gate oxide and subsequently into the channel of the MOSFET. This can lead to a change in the threshold voltage of the device.

Pre-amorphization by a silicon or germanium implant prior to the dopant implant eliminates ion-channeling completely. Pre-amorphization creates an amorphous layer in the crystalline substrate. However, it also creates defects (interstitials) beyond the amorphous layer/crystalline substrate (a/c) interface. The amorphous layer created is typically wide enough to just contain the as-implanted dopant profile. A high temperature anneal is needed to remove the damage introduced by the implant. After annealing, the junction is placed beyond the original amorphous/crystalline (a/c) interface to prevent the depletion region under reverse bias from extending to include the defects beyond the a/c interface and thus result in excessive leakage. The high temperature anneal, however, results in TED of the dopant atoms due to the defects (interstitials) present beyond the a/c interface of the amorphous layer. Consequently, the junctions are much deeper and the advantage due to elimination of channeling is lost for shallow junctions.

Another approach using pre-amorphization is to have a much deeper amorphous layer. This reduces both channeling and TED completely. However, the defects also spread out laterally under the gate region of the MOSFET and lead to enhanced leakage due to band-to-band tunneling or gate induced drain leakage.

### SUMMARY OF THE INVENTION

A method for tailoring the dopant profile of a doped region is disclosed herein. A sub-amorphization implant of a non-electrically active material such as silicon or germanium is performed before a dopant implant. The energy of the sub-amorphization implant is optimized to achieve the desired dopant profile. A lower energy, for example, produces a gradual junction, whereas, a higher energy can be used to produce a shallower junction region. In one application of the invention, a drain extension region of a MOSFET is formed using a sub-amorphization implant of silicon or germanium prior to a implant of boron. The energy of the sub-amorphization implant is chosen so that its projected range (i.e., location of interstitial excess due to sub-amorphization implant) is greater than three times the as-implanted junction depth of the boron implant in amorphous silicon. This places the interstitials away from the junction region to reduce TED.

An advantage of the invention is providing a method of forming a doped region having a tailored dopant profile.

Another advantage of the invention is providing a method of forming a doped region that can be tailored to have a reduced channeling tail and TED resulting in shallower junctions.

Another advantage of the invention is providing a method of forming a doped region that avoids the problems associated with an amorphous layer/crystalline substrate interface.

These and other advantages will be apparent to those of ordinary skill in the art having reference to the specification in conjunction with the drawings and claims.

### BRIEF DESCRIPTION OF THE DRAWINGS

The present invention will now be further described, by way of example, with reference to the accompanying drawings in which:
FIG. 1 is a cross-sectional diagram of a MOSFET according to the invention;
FIGs. 2a-2c are cross-sectional diagrams at various stages in the process of the invention;
FIG 3 is graph of dopant concentration versus distance within a substrate for as-implanted boron profiles for a 5 keV, 6e14 cm⁻² BF₂⁺ implant with and without a 50 keV, 4e14 cm⁻² Si⁺ pre-implant;
FIG. 4 is a graph of dopant concentration versus distance within a substrate for boron profiles after anneal for a 5 keV, 6e14 cm⁻² BF₂⁺ implant with a 4e14 cm⁻² Si⁺ pre-implant at energies of 30, 50, and 60 keV;
FIG. 5 is a graph of dopant concentration versus distance within a substrate for boron profiles after anneal for a 5 keV, 6e14 cm⁻² BF₂⁺ implant with and without a 60 keV, 4e14 cm⁻² Si⁺ pre-implant; and
FIG. 6 is a graph of dopant concentration versus distance within a substrate for boron profiles for a 5 keV, 2e14 cm⁻² B⁺ implant with and without a 26 or 100 keV, 4e14 cm⁻² Si⁺ pre-implant.

Corresponding numerals and symbols in the different figures refer to corresponding parts unless otherwise indicated.

### DETAILED DESCRIPTION OF PREFERRED EMBODIMENTS

The invention will be described in conjunction with forming a shallow drain extension region for a p-type MOSFET transistor. It will be apparent to those of ordinary skill in the art that the invention is applicable to forming doped regions in a semiconductor substrate generally and may be used to tailor the doping profile of the doped region for either a sharper junction (shallower region) or a more gradual junction.

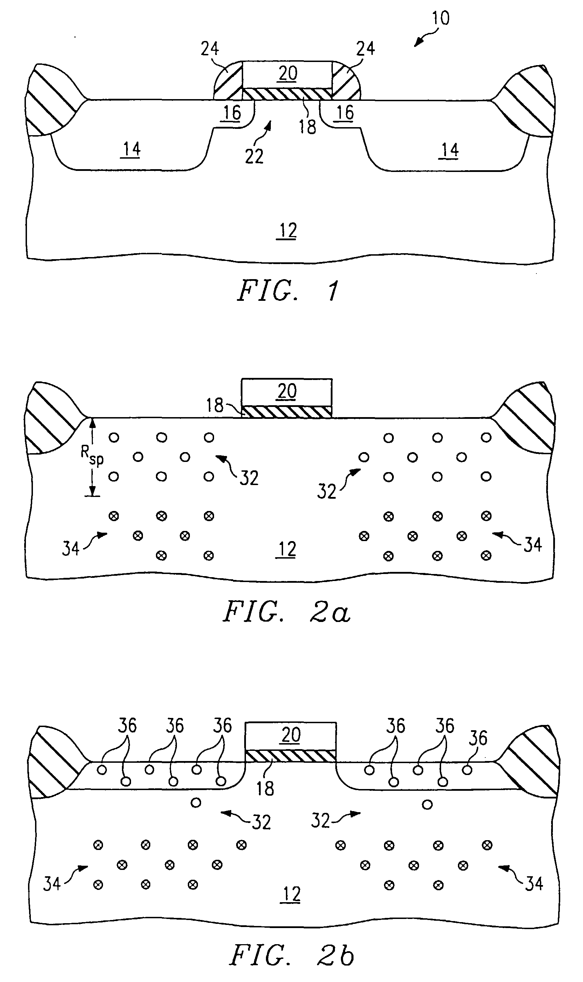

A p-type MOSFET 10 according to the invention is shown in Figure 1. MOSFET 10 is formed in substrate (or well) 12. Source/drain regions 14 are heavily doped p-type regions located in substrate 12. Drain extension regions 16 are more lightly doped than source/drain regions 14 but are also p-type. Drain extension regions 16, according to the invention, are shallower than prior art p-type drain extension regions. Having shallower drain extension regions 16 allows the channel length of MOSFET 10 to be scaled down to below its present limits while still preventing short channel effects. Gate electrode 20 is separated from channel region 22 by gate dielectric 18. Gate electrode 20 typically includes a sidewall dielectric 24 on its vertical edges.

MOSFET 10 may be formed by conventional techniques except for the formation of drain extension regions 16. A method for forming drain extension regions 16 within MOSFET 10 will now be described with reference to Figures 2a-2c.

If the p-type dopant were implanted immediately after the formation of gate electrode 20, the channeling tail during the p-type dopant implant and the TED during the subsequent anneal would cause the junction to be much deeper than desired. The channeling tail is created during the implant of the p-type dopant through channels in the substrate microstructure. TED is caused by the pairing of the dopant atom and the interstitial which diffuses much faster than the dopant atom alone.

Instead of implanting the p-type dopant after the formation of gate electrode 20, a sub-amorphization implant of a non-electrically active species is performed. The non-electrically active species is preferably selected from Group IV of the Periodic Table, such as silicon or germanium. The implant is sub-amorphizing to avoid creating an amorphous layer at the surface of the substrate 12. The problems associated with forming an amorphous layer have been discussed previously.

The energy of the sub-amorphization implant is chosen based on the dopant profile desired. For example, if a gradual dopant profile is desired, a low energy implant is used. However, in this case a shallow, more abrupt junction is desired. Therefore, a higher energy implant is used. The energy of the implant determines the projected range of the implanted species. A low energy has a shorter projected range and can leave interstitials within the projected range of the dopant implant. Because of TED effects, this would create a deeper, more gradual dopant profile. A high energy implant has a deeper projected range. This can place the interstitials well beyond the projected range of the dopant implant and reduce TED. Thus, a higher energy is desired for forming drain extension regions 16.

As shown in Figure 2a, the sub-amorphization implant creates excess vacancies 32 in the near surface region and places the excess interstitials 34 beyond this region. The excess vacancies 32 tend to lie between the surface and approximately 0.8Rₚₛ, where Rₚₛ is the projected range of the sub-amorphization implant. The creation of excess vacancies creates enough strain in the lattice of the substrate to prevent ion channeling (i.e. the channeling tail of the subsequent dopant implant). The excess interstitials tend to lie between Rₚₛ and 2Rₚₛ. The energy of the sub-amorphization implant was chosen such that the Rₚ of the Si⁺ implant (i.e. shallow end of the location of interstitial excess distribution) is more than 3 times deeper than the as-implanted junction depth of the B⁺ or BF₂⁺ implant in amorphous Si. This was done keeping in view the fact that, 1) the as-implanted junction depths were calculated in amorphous silicon and the actual as-implanted dopant profile would be deeper than this value since channeling would not be completely eliminated, and 2) this depth (i.e. Rₚ of Si⁺ implant) is approximately equal to the depth to which the dopants would diffuse in the absence of the Si⁺ pre-implant, thus ensuring that the interstitial excess is far away from the dopants. Approximate final dopant profiles were estimated using T-SUPREM III simulations. While using this approach to fabricate the S/D extension regions of LDD MOSFETs, the energy of the Si⁺ pre-implant should not be so high as to penetrate the polysilicon layer on top the gate oxide; otherwise it may degrade the gate oxide quality. The relationship between implant energy and projected range for different species is well documented in the art. (For example, see, Runyan et al, Semiconductor Integrated Circuit Processing Technology, 1990, p. 481.) Some exemplary sub-amorphization implants include a 100 keV Si⁺ pre-implant followed by a 5 keV, 2e14 cm⁻² B⁺ implant through 190 A of SiO₂; a 80 keV Si⁺ pre-implant followed by a 15 keV, 3.5e14 cm⁻² BF₂⁺ implant through 190 A of SiO₂; a 60 keV Si⁺ pre-implant followed by a 8 keV, 6e14 cm⁻² BF₂⁺ implant through 70 Å of SiO₂; and a 50 keV Si⁺ pre-implant followed by a 5 keV 6e14 cm⁻² BF₂⁺ implant through 70 Å SiO₂. The dopant species, dopant dose, dopant energy and the thickness of the screen oxide determine the depth of the dopant profile which in turn determines the energy of the Si⁺ pre-implant.

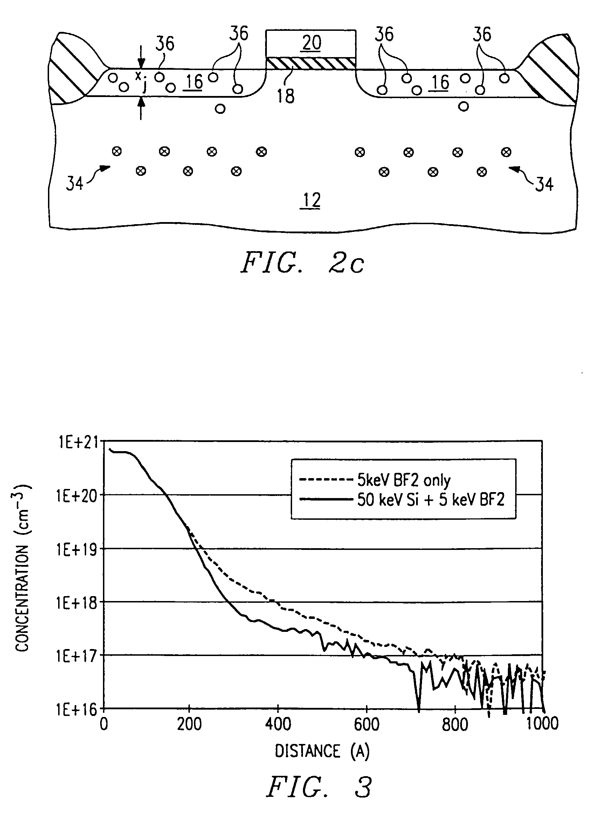

Next, the p-type dopant, 36, is implanted at the desired dose and energy, as shown in Figure 2b. The p-type dopant is preferably boron, but may be BF₂ or some other p-type dopant as well. As shown in Figure 2c, an anneal is performed next to diffuse the p-type dopant, 36, to the desired junction depth xⱼ after anneal. The Rₚₛ was chosen such that it is greater than the final simulated junction depth, xⱼ. This assures that the interstitials 34 are place well beyond the junction to suppress TED. The reduction in TED is greater for B⁺ implants than for BF₂⁺ implants. Processing then continues in a conventional manner to form sidewall dielectrics and source/drain regions.

The threshold dose for a room temperature silicon implant is 2e15cm⁻² to create amorphization. A sub-amorphization implant is desired for the invention. Therefore, a sub-amorphization dose of 4e14 cm⁻² was chosen for the silicon pre-implants described below. Figure 3 shows the as-implanted profiles for 5 keV, BF₂⁺ implant for a dose of 6e14 cm⁻² with and without a silicon pre-implant. A 50 keV silicon pre-implant is used and has a projected range of 696 Å. Since the implant is performed through 70 Å of SiO₂ (which is equivalent to 96 Å of Si for purposes of calculating the range of Si⁺ in Si), the interstitial excess is located at 600 Å. This is beyond the tail of the as-implanted profile. There is a reduction in the channeling tail of the 5 keV BF₂⁺ implant. The as-implanted dopant profile lies within the vacancy excess of the Si⁺ pre-implant which extends roughly from the surface to approximately 0.8Rₚₛ. (i.e., 480 Å). The vacancy excess creates enough strain in the lattice which prevents ion channeling, thus minimizing the channeling tail.

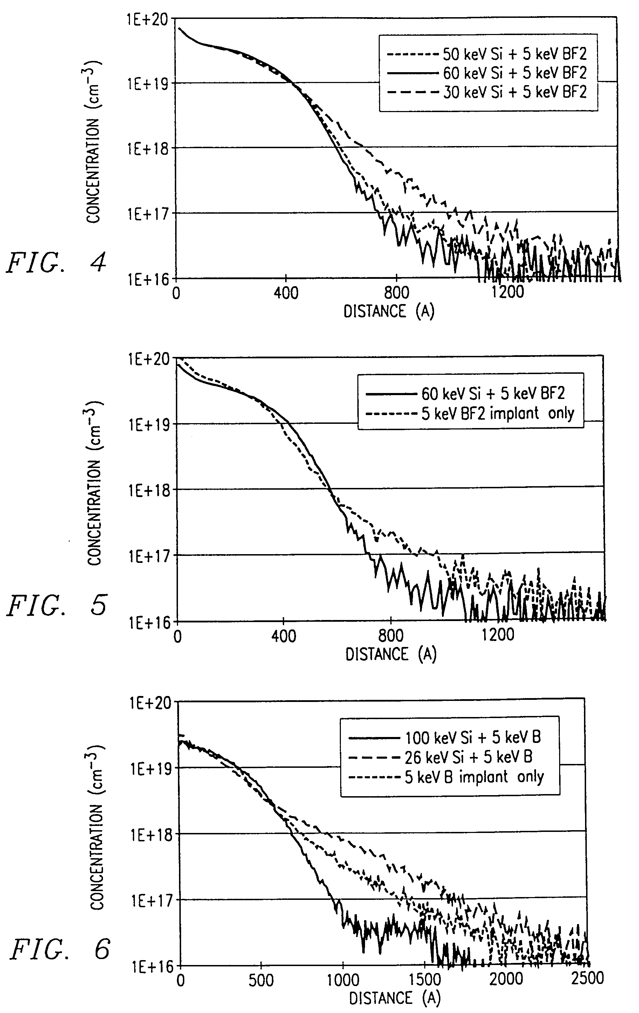

Figure 4 shows boron profiles for a 5keV, 6e14 cm⁻² BF₂⁺ implant preceded by a Si⁺ implant of 30, 50, or 60 keV at a fixed dose of 4e14 cm⁻². All of the implants were performed through a 70 Å screen oxide layer. Three successive anneals: a Rapid Thermal Anneal (RTA) at 900°C, then a furnace anneal at 700°C, followed by an RTA at 1000°C. As seen in Figure 4, as the energy of the Si⁺ pre-implant increases, the dopant profile becomes shallower. The projected range of the 30, 50, and 60 keV implants are 413, 696, and 845 Å, respectively. Taking into account the 70 Å screen oxide, the excess interstitial distribution is place roughly around 317, 600, and 749 Å in the Si substrate for the 30, 50, and 60 keV pre-implants, respectively. The dopant profiles get progressively shallower for higher Si energies, since the excess interstitial distribution is moved farther and farther away from the dopant profile (i.e., less TED). The excess vacancy distribution also coincides with the dopant profile and these vacancies recombine with the interstitials produced by the dopant implant to further reduce TED. The B profiles obtained using a 5 keV BF₂⁺ implant with and without a 60 keV Si⁺ pre-implant are compared in Figure 5 to show the net reduction in TED.

If the excess interstitial distribution produced by the Si⁺ pre-implant is not far enough from the dopant implant, the Si⁺ pre-implant may actually increase TED. The 30 keV Si⁺ pre-implant actually increases the TED as the interstitials created by this implant are too close to the dopant distribution and thus, contribute to TED. The interstitials pair with the Boron atoms to give rise to enhanced diffusion. For the same implant dose, as the energy increases, the damage also increases. However, the interstitials are further away from the dopant atoms due to higher Rₚₛ. Hence, there is a reduction in TED for a BF₂⁺ implant preceded by a higher energy Si⁺ implant.

Figure 6 shows a comparison of boron profiles following a 5keV, 2e14 cm⁻³ B⁺ implant, with and without a Si⁺ pre-implant at 26 and 100 keV at a sub-amorphizing dose of 4e14 cm⁻². These implants were performed through a 190 Å screen oxide layer and the samples were annealed, first at a furnace anneal at 800 °C and then a RTA at 1000 °C. The optimum Si⁺ implant at 100 keV reduces the junction depth by 450 Å at a background concentration of 1e17 cm⁻³. The Rp of the 100 and 26 keV Si⁺ implants are 1469 and 350 Å, respectively. The 100 keV Si⁺ pre-implant produces an interstitial excess beyond 1217 Å in silicon (190 A of SiO₂ is equivalent to approximately 250 Å of silicon for calculating the range of Si⁺ in the silicon substrate). This is effective in reducing the TED and results in a shallower profile. The Si⁺ pre-implant at 26 keV, however, increases the TED and results in a B profile deeper than the one without the Si⁺ pre-implant since the interstitial excess is much closer to the dopant profile.

The feasibility of using this technique in a 0.35 µm gate length CMOS technology has been demonstrated. A Si⁺ sub-amorphizing threshold implant was used prior to the B or BF₂⁺ dopant implant for forming the S/D extension regions of an LDD p-MOSFET. Gate oxide thickness was 55 Å. The values of the combination of B⁺ and BF₂⁺ implants and the Si⁺ pre-implants used for S/D extension regions are as follows:
Wafer #1 : 50 keV Si⁺ followed by 5 keV, 6e14 cm⁻² BF₂⁺ implant through 70 Å SiO₂
Wafer #2 : 60 keV Si⁺ followed by 8 keV, 6e14 cm⁻² BF₂⁺ implant through 70 Å SiO₂
Wafer #3 : 80 keV Si⁺ followed by 15 keV, 3.5e14 cm⁻² BF₂⁺ implant through 190 Å SiO₂
Wafer #4 : 100 keV Si⁺ followed by 5 keV, 2e14 cm⁻² BF₂⁺ implant through 70 Å SiO₂
The dose for all the Si⁺ implants was 4e14 cm⁻². The thickness of the polysilicon layer on top of gate oxide was 2700 Å. The final high temperature anneal was an RTA at 1000°C. For the four different conditions described above using a Si⁺ sub-threshold dose pre-implant some of the relevant device characteristics are described in the Table I below.

**Table I**

| Device Characteristics of the samples/wafers described above | | | | |
|---|---|---|---|---|
| | Sample 1 | Sample 2 | Sample 3 | Sample 4 |
| Vt Sat.,L=0.35µm (Vd=-2.5V) | -0.58 V | -0.56 V | -0.57 V | -0.54 V |
| Vt Lin.,L=0.35µm (Vd=-0.05V) | -0.63 V | -0.61 V | -0.62 V | -0.61 V |
| Vt roll-off, Sat. L=0.315 to 0.455µm | -0.52 to -0.61 V | -0.5 to -0.6 V | -0.49 to -0.63 V | -0.44 to -0.62 V |
| Vt roll-off, Lin. L=0.315 to 0.455µm | -0.6 to -0.65 V | -0.58 to -0.64 V | -0.58 to -0.67 V | -0.54 to -0.65 V |
| Ion (mA/µm) | 188 | 207 | 207 | 219 |
| Ioff (pA/µm) | 3.5 | 4.1 | 2.7 | 3.5 |
| Sub-threshold Slope mV/decade,(Vt=-2.5V) | 84 | 82 | 80 | 84 |
| Sub-threshold Slope mV/decade,(Vt=-0.05V) | 84 | 82 | 80 | 84 |
| S/D resistance (Ω/µm) | 934 | 741 | 1041 | 1089 |

The leakage currents for all the four samples are extremely low, indicating that no defects were created using the Si⁺ pre-implant. All the parameters examined were within the specifications for this technology node. The reduction of short channel effects due to the shallower LDD devices will become more apparent in next generation, shorter gate length devices.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for forming doped regions in a substrate, comprising the steps of:
implanting a non-electrically active species into said substrate at a sub-amorphizing level to a first projected range; and
implanting a dopant into said substrate and annealing said substrate to obtain a given junction depth, (xj).

2. The method of claim 1, wherein said step of implanting a non-electrically active species comprises implanting said non-electrically active species to a first projected range that is greater than said junction depth, (xj), to obtain shallow and abrupt junctions.

3. The method of claim 1, wherein said step of implanting a non-electrically active species comprises implanting said non-electrically active species to a first projected range that is less than said junction depth, (xj), to obtain deep and gradual junctions.

4. The method of any preceding claim, wherein said step of implanting a non-electrically active species comprises implanting a non-electrically active species that is a group IV element on the Periodic Table.

5. The method of Claim 4, wherein said step of implanting a non-electrically active species comprises implanting a non-electrically active species comprising silicon.

6. The method of Claim 4, wherein said step of implanting a non-electrically active species comprises implanting a non-electrically active species comprising germanium.

7. The method of any preceding claim, wherein said step of implanting said dopant comprises implanting a dopant comprising boron.

8. The method of any of Claims 1 to 6, wherein said step implanting said dopant comprises implanting a dopant comprising BF₂⁺.

9. The method of any preceding claim, further comprising forming a doped region that is shallow and wherein said step of implanting a non-electrically active species is performed at an energy governed by the dopant dose, dopant energy and screen oxide thickness.

10. A device formed according to the method of any of Claims 1 to 9.

11. A method for forming a shallow drain extension region of a MOSFET transistor in a substrate comprising the steps of:
implanting a species selected from Group IV of the periodic table into a region of said substrate at a sub-amorphizing level to a first projected range of the order of three times greater than a simulated, as- implanted junction depth;
implanting a dopant into said region of said substrate at a desired dose and energy approximately corresponding to said simulated as-implanted junction depth; and
annealing said substrate to diffuse said dopant.

12. The method of Claim 11, wherein said step of implanting said dopant comprises implanting a dopant that is diffused to a junction depth less than said first projected range.

13. The method of Claim 11, wherein said step of implanting said dopant comprises implanting dopant comprising boron.

14. The method of any of Claims 11 to 13, wherein said step of implanting said species comprises implanting a species comprising silicon.

15. The method of any of Claims 11 to 13, wherein said step of implanting said species comprises implanting a species comprising germanium.

16. A device formed according to the method of any of Claims 11 to 15.
